# EUROPEAN PATENT APPLICATION

(11) **EP 2 056 395 A1**
(43) Date of publication of application: **06.05.2009**
(21) Application number: 07021466.3
(22) Date of filing: 05.11.2007
(51) Int. Cl.: H01Q 1/24, H01Q 7/00

(54) **Antenna device and portable radio communication device comprising such antenna device**

(71) Applicant: Laird Technologies AB, 164 22 Kista (SE)
(72) Inventor: Lindberg, Peter, 752 29 Uppsala (SE); Kaikkonen, Andrei, 164 71 Kista (SE)
(74) Representative: Fritzon, Rolf

(57) **Abstract**

The present invention relates to an antenna device for a portable radio communication device adapted for receiving radio signals in at least a first operating frequency band. The antenna device comprises a radiating element (1) comprising a feeding portion and a tuning capacitor (2) connected to the feeding portion of the radiating element. The antenna device further comprises a low pass filter (3) connected to the feeding portion and to a high impedance low noise amplifier (4) for the at least a first operating frequency band, between the tuning capacitor and the high impedance low noise amplifier.

## Description

### FIELD OF INVENTION

The present invention relates generally to antenna devices and more particularly to an antenna device for use in a radio communication device, such as a mobile phone, which antenna device is adapted for radio signals having a relatively low frequency, such as radio signals in the AM and/or FM frequency band.

### BACKGROUND

Internal antennas have been used for some time in portable radio communication devices. There are a number of advantages connected with using internal antennas, of which can be mentioned that they are small and light, making them suitable for applications wherein size and weight are of importance, such as in mobile phones, PDA, portable computer or similar devices.

However, the application of internal antennas in a mobile phone puts some constraints on the configuration of the antenna element. In particular, in a portable radio communication device the space for an internal antenna device is limited. These constraints may make it difficult to find a configuration of the antenna device that provides for a wide operating band. This is especially true for antennas intended for use with radio signals of relatively low frequencies as the desired physical length of such antennas are large compared to antennas operating with relatively high frequencies.

One specific application operating in a relatively low frequency band is the FM radio application. The FM band is defined as frequencies between 88-108 MHz in most of the world or between 76-90 MHz in Japan. Prior art conventional antenna configurations, such as loop antennas or monopole antennas, fitted within the casing of a portable radio communication device will result in unsatisfactory operation in that the antenna either has too bad performance over a sufficiently wide frequency band or sufficient performance over a too narrow frequency band.

Instead, a conventional FM antenna for portable radio communication devices is provided in the headset wire connected to the communication device. This configuration with a relatively long wire permits an antenna length that is sufficient also for low frequency applications. However, if no external antenna is permitted this solution is obviously not feasible.

Another problem is that in case a second antenna, such as a GSM antenna, is provided in the same communication device as the FM antenna, this second antenna interferes with the operation of the FM antenna.

### SUMMARY OF THE INVENTION

An object of the present invention is to provide an internal antenna device for use in a portable radio communication device, which operates with sufficient performance throughout a frequency band having a relatively low frequency, such as the AM and/or FM radio band.

According to the present invention there is provided an antenna device for a portable radio communication device adapted for receiving radio signals in at least a first operating frequency band, the antenna device comprising a radiating element comprising a feeding portion, and a tuning capacitor connected to the feeding portion of the radiating element, wherein the antenna device further comprises a low pass filter connected to the feeding portion of the radiating element and to a high impedance low noise amplifier for the at least a first operating frequency band, between the tuning capacitor and the high impedance low noise amplifier.

A portable radio communication device comprising such an antenna device is also provided.

The antenna device according to the invention provides operation with sufficient performance throughout a frequency band having a relatively low frequency, such as the AM and/or FM radio band. By using a low pass filter between the tuning capacitor and the low noise of the antenna device, it has been found that the low pass filter is virtually lossless for the desired operating frequency band, at the same time rejecting higher frequencies such as GSM frequencies.

In a preferred embodiment, the low pass filter comprises series inductor means. The series inductor means also improves protection of ESD (electrostatic discharges) pulses. The inductor means comprises at least an inductor in the most straightforward solution. However, the inductor means comprises a plurality of series inductors for strong responses in separated centre frequencies, such as GSM900 and GSM1800. A series inductor means having very strong response over a broad frequency band is a solenoid, preferably provided with a ferrite core.

For improved protection against ESD pulses the antenna device preferably further comprises a transient voltage suppressor means connected to the feeding portion between the tuning capacitor and the radiating element. The transient voltage suppressor means is e.g. provided as anti-parallel diodes.

The radiating element is preferably a half-loop radiating element. Alternatively the radiating element is a loop radiating element, and the feeding portion is a differential feeding portion, and the antenna device comprises a tuning capacitor and a low pass filter for each feeding portion of the differential feeding portion.

The first operating frequency band is preferably the FM band.

Further preferred embodiments are defined in the dependent claims.

### BRIEF DESCRIPTION OF DRAWINGS

The present invention will become more fully understood from the detailed description of embodiments given below and the accompanying figures, which are given by way of illustration only, and thus, are not limitative of the present invention, wherein:
FIG. 1 is a schematic diagram showing an antenna device according to the present invention connected to an FM receiver circuit.
FIG. 2 is a perspective partially cut-away view of an antenna device according to the invention mounted in a portable radio communication device.
FIG. 3 is a schematic diagram showing a second embodiment of an antenna device according to the present invention.
FIG. 4 is a schematic diagram showing the antenna device illustrated in FIG. 1 provided with transient voltage suppressor means.

### DETAILED DESCRIPTION OF THE INVENTION

In the following description, for purpose of explanation and not limitation, specific details are set forth, such as particular techniques and applications in order to provide a thorough understanding of the present invention. However, it will be apparent for a person skilled in the art that the present invention may be practiced in other embodiments that depart from these specific details. In other instances, detailed description of well-known methods and apparatuses are omitted so as not to obscure the description of the present invention with unnecessary details.

In the following description and claims, the term radiating element is used. It is to be understood that this term is intended to cover electrically conductive elements arranged for receiving radio signals.

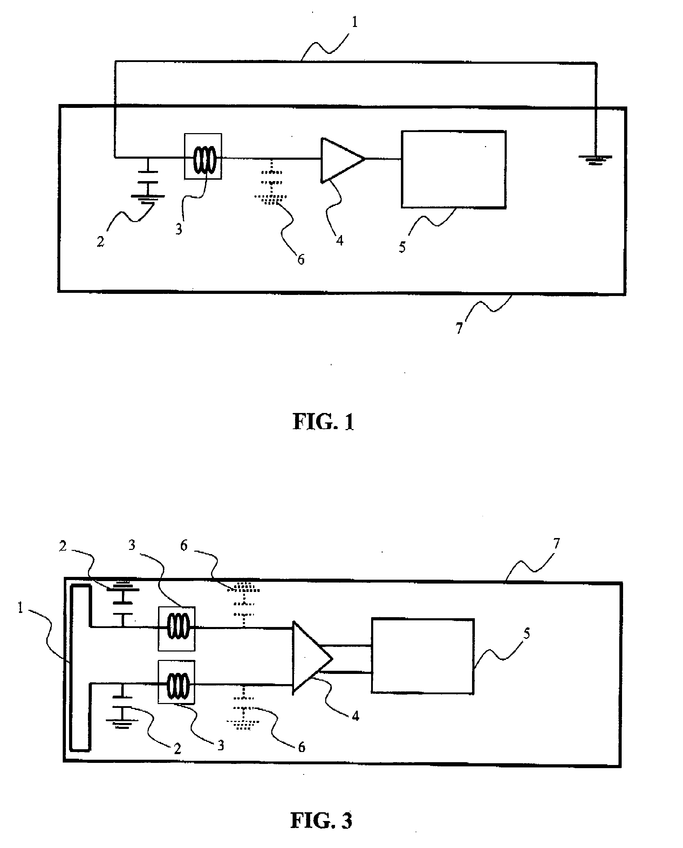

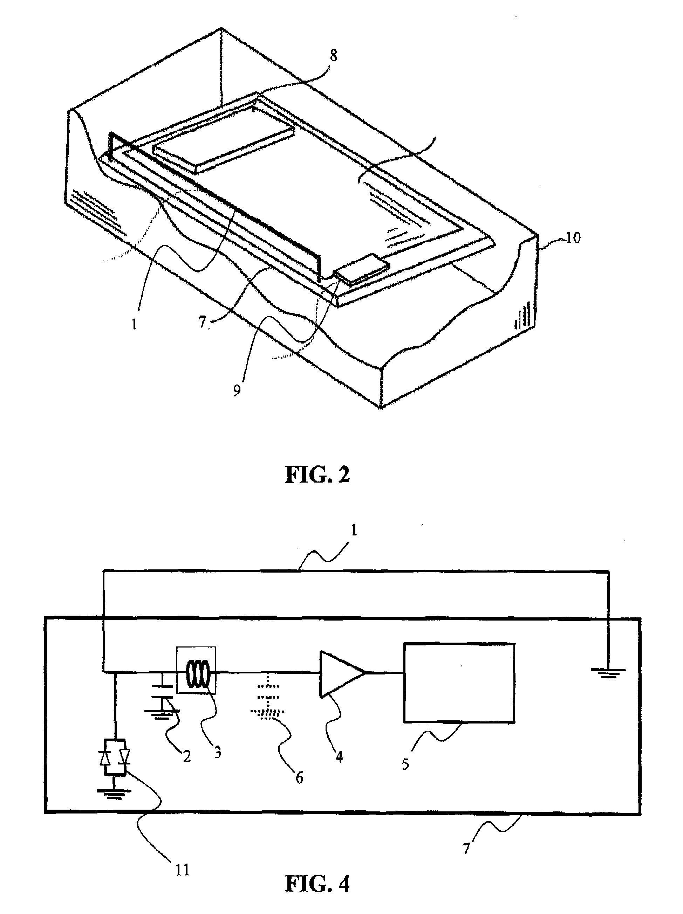

With reference to Figs. 1 and 2 an antenna device according to the present invention is described. The antenna device comprises a radiating element 1 in the form of a non-resonant piece of electrically conductive material, such as sheet metal or flex film. The radiating element is preferably a half-loop antenna, i.e. grounded in one end and fed in the other end and running over a ground plane means, such as a printed wiring board (PWB) 7 or a metal ground plane, to provide a virtual loop antenna.

The radiating element 1 has a feeding portion connected to a tuning capacitor 2 arranged to resonate with the radiating element in a first operating frequency band, such as FM. In the case of operation in the FM band, the frequency band is between 88-108 MHz in e.g. Europe or between 76-90 MHz in Japan. Signals received by the antenna device are amplified by a high impedance LNA (low noise amplifier) 4 connected to the feeding portion, which high impedance LNA in turn is connected to an FM receiver circuit 5. An intrinsic impedance of the high impedance LNA 5 is illustrated as capacitor 6 in the drawings (shown with dashed lines).

It is preferred that the tuning capacitor 2 is provided relatively close to the radiating element 1 in order to minimize parasitic effects and interference from external sources.

The tuning capacitor 2 parallel with the radiating element 1 exhibit approximately a capacitive impedance of about 1 kΩ for FM frequencies. The intrinsic capacitor 6 also exhibits approximately a capacitive impedance of about 1 kΩ for FM frequencies. A low pass filter 3 is connected to the feeding portion and to the high impedance LNA 5, i.e. between the tuning capacitor and the high impedance LNA 5 (or directly upstream of the high impedance LNA 5). The low pass filter 5 is preferably a series inducting means, such as an inductor. The low pass filter 3 preferably has an impedance of less than 1 kΩ for FM frequencies, thereby being virtually lossless for the antenna device, as it is positioned between two larger impedances. For higher frequencies the low pass filter will have higher impedance.

The inductor of the series inducting means is preferably a discrete component, which is a simple low pass filter, which works as both crosstalk rejection of higher frequency signals, such as GSM, as well as protection from ESD pulses to some degree. For improved crosstalk rejection several series inductors can be used. By providing e.g. one 10 nH inductor, one 100 nH inductor and one 1000 nH inductor in series strong rejection response is achieved for 300-5000 MHz.

By providing the series inducting means as a solenoid a strong response over a broad frequency band is achieved. This effect is further improved by providing the solenoid with a ferrite core.

The high impedance LNA 4 and the low pass filter 3 can alternatively be comprised in a circuit device, such as an ASIIC, which also could comprise further components.

For improved ESD pulse protection a transient voltage suppressor means 11 is preferably provided connected to the feeding portion of the radiating element 1, between the tuning capacitor 2 and the radiating element 1. A straight forward transient voltage suppressor means is e.g. provided as anti-parallel diodes.

The FM antenna radiating element is preferably placed so that it is connected to the FM circuit at the end of the PWB opposite to the end where the radiating element is provided. The radiating element then runs along a long side of the PWB until it reaches the other end of the PWB, where it is grounded to the ground plane provided on the PWB.

In order to make the antenna device less sensitive to orientation of the portable radio communication device, the radiating element can be provided so that it also runs along a short side of the PWB, before it is grounded to the ground plane provided on the PCB.

An alternative implementation of the inventive idea in the form of a second embodiment will now be described with reference to FIG. 3. Like the above described first embodiment, this antenna device comprises a radiating element 1 having a feed portion, and a tuning capacitor 2. However, in this second embodiment the radiating element is a loop antenna having a differential feeding, connected to a high impedance differential LNA.

The antenna device thus comprises twin sets of feeding portion, tuning capacitor and low pass filter of the first embodiment described above. Each end of the loop radiating element has a tuning capacitor and low pass filter, each of which low pass filter is connected to a respective part of the high impedance differential LNA.

It will be obvious that the present invention may be varied in a plurality of ways. Such variations are not to be regarded as departure from the scope of the present invention as defined by the appended claims. All such variations as would be obvious for a person skilled in the art are intended to be included within the scope of the present invention as defined by the appended claims.

## Claims

1. An antenna device for a portable radio communication device adapted for receiving radio signals in at least a first operating frequency band, said antenna device comprising
a radiating element (1) comprising a feeding portion, and
a tuning capacitor (2) connected to said feeding portion of the radiating element (1),
**characterized in that**
said antenna device comprises a low pass filter (3) connected to said feeding portion of the radiating element (1) and to a high impedance low noise amplifier (4) for said at least a first operating frequency band, between said tuning capacitor (2) and said high impedance low noise amplifier (4).

2. The antenna device according to claim 1, wherein said low pass filter comprises series inductor means.

3. The antenna device according to claim 2, wherein said series inductor means comprises at least an inductor.

4. The antenna device according to claim 3, wherein said series inductor means comprises a plurality of series inductors.

5. The antenna device according to claim 3 or 4, wherein said inductor comprises a solenoid.

6. The antenna device according to claim 5, wherein said solenoid comprises a ferrite core.

7. The antenna device according to any of claims 1-6, comprises a transient voltage suppressor means (11) connected to said feeding portion between said tuning capacitor and said radiating element.

8. The antenna device according to any of claims 1-7, wherein said radiating element is a half-loop radiating element, and said antenna device comprises a ground plane means.

9. The antenna device according to any of claims 1-7, wherein said radiating element is a loop radiating element, and said feeding portion is a differential feeding portion, and said antenna device comprises a tuning capacitor and a low pass filter for each feeding portion of the differential feeding portion.

10. The antenna device according to any of claims 1-9, wherein the first operating frequency band is the FM band.

11. A portable radio communication device comprising an antenna device according to any of the preceding claims.

12. A circuit device for a portable radio communication device adapted for receiving radio signals in at least a first operating frequency band,
**characterized in**
- a high impedance low noise amplifier (4), arranged to amplify radio signals in said first operating frequency band, and
- a low pass filter (3), arranged to pass signals in said first operating frequency band, wherein said low pass filter (3) is provided directly upstream of said high impedance low noise amplifier (4).
